(19) **Europäisches Patentamt**

**European Patent Office**

**Office européen des brevets**

(11) **EP 0 909 421 B1**

(12) **EUROPÄISCHE PATENTSCHRIFT**

(45) Veröffentlichungstag und Bekanntmachung des Hinweises auf die Patenterteilung:
**01.03.2000   Patentblatt 2000/09**

(21) Anmeldenummer: **97930330.2**

(22) Anmeldetag: **17.06.1997**

(51) Int Cl.$^7$: **G06F 17/50**

(86) Internationale Anmeldenummer:
**PCT/DE97/01231**

(87) Internationale Veröffentlichungsnummer:
**WO 98/01812 (15.01.1998 Gazette 1998/02)**

(54) **VERFAHREN UND ANORDNUNG ZUR RECHNERGESTÜTZTEN ERMITTLUNG EINER SYSTEMZUSAMMENHANGSFUNKTION**

COMPUTER-ASSISTED PROCESS FOR DETERMINING A SYSTEM CONSISTENCY FUNCTION

PROCEDE DE DETERMINATION ASSISTEE PAR ORDINATEUR D'UNE FONCTION DE CONVERGENCE D'UN SYSTEME

(84) Benannte Vertragsstaaten:
**DE FR GB IT**

(30) Priorität: **04.07.1996  DE 19626984**

(43) Veröffentlichungstag der Anmeldung:
**21.04.1999   Patentblatt 1999/16**

(73) Patentinhaber: **SIEMENS AKTIENGESELLSCHAFT**
**80333 München (DE)**

(72) Erfinder:
• **KAHLERT, Martin**
  **D-85229 Karpfenhofen (DE)**
• **FELDMANN, Jörg-Uwe**
  **D-81827 München (DE)**
• **WEVER, Utz**
  **D-81539 München (DE)**

(56) Entgegenhaltungen:
**EP-A- 0 690 396          US-A- 5 313 398**
**US-A- 5 379 231**

**Beschreibung**

Durch eine immer weiter wachsende Integrationsdichte bei elektrischen Schaltungen (VLSI) werden Ermittlungen von Systemzuständen einer elektrischen Schaltung, beispielsweise durch eine Schaltungssimulation, immer komplexer. Es sind heutzutage schon derartige Integrationsdichten erreicht, daß sogar parasitäre Effekte, beispielsweie Überspracheffekte zwischen Leitungen, die die einzelnen Komponenten der elektrischen Schaltung miteinander verbinden, berücksichtigt werden müssen. Die Leitungen werden üblicherweise als lineare Komponenten, beispielsweise als eine Folge von RC-Gliedern, modelliert. Bei einer hohen Integrationsdichte führt die zusätzliche Modellierung von Leitungen zu einer erhöhten Anzahl von Mengen miteinander gekoppelter linearer Komponenten innerhalb einer elektrischen Schaltung, die jeweils mit nichtlinearen Komponenten der elektrischen Schaltung gekoppelt sind. Es entstehen, anschaulich dargestellt, "Inseln" von miteinander gekoppelten linearen Komponenten in einer zu untersuchenden elektrischen Schaltung.

Die hohe Anzahl von gekoppelten linearen Komponenten, die beispielsweise durch Modellierung der parasitären Effekte bei Leitungen verursacht werden, stellen Anforderungen an die Rechner, die die einzelnen elektrischen Schaltungen untersuchen, die derzeit selbst von sehr leistungsfähigen Rechnern nicht erfüllt werden können.

Ein sogenannter Eigenwert-Solver zur Ermittlung von Eigenwerten für ein homogenes Differentialgleichungssystem ist aus dem Dokument [1] bekannt.

Ferner ist es bekannt, für eine Menge gekoppelter linearer Komponenten eine Übertragungsfunktion zu ermitteln. Dieses Verfahren ist aus dem Dokument [2] bekannt.

Ferner ist es aus dem Dokument [3] bekannt, bei der Approximation einer Übertragungsfunktion für eine Menge gekoppelter linearer Komponenten einer elektrischen Schaltung nur den sogenannten dominanten Eigenwert zu berücksichtigen.

Ferner ist es aus dem Dokument [4] bekannt, für eine Menge linearer Komponenten mehrere Übertragungsfunktionen separat zu ermitteln, die somit jeweils das Verhalten der Menge linearer Komponenten bezüglich zweier Referenzanschlüsse für die jeweilige Übertragungsfunktion beschreiben.

Das Verfahren aus dem Dokument [2] weist den Nachteil auf, daß bei diesem Verfahren nur der Zustand der Menge linearer Komponenten lediglich bezüglich zweier Anschlüsse der Menge linearer Komponenten mit nichtlinearen Komponenten berücksichtigt wird. Eine Berücksichtigung von einer größeren Anzahl von Anschlüssen an weitere nichtlineare Komponenten ist mit diesem Verfahren nicht möglich.

Das aus dem Dokument [4] bekannte Verfahren weist v. a. den Nachteil auf, daß zwar mehrere Anschlüsse der Menge linearer Komponenten mit linearen Komponenten berücksichtigt werden, diese jedoch jeweils immer nur paarweise, so daß zum einen ein hoher Bedarf an Rechenkapazität für die Durchführung dieses Verfahrens benötigt wird und zum anderen die Genauigkeit der Ergebnisse, die durch dieses Verfahren erzielt werden, sehr gering ist.

Somit liegt der Erfindung das Problem zugrunde ein Verfahren zur Ermittlung einer Systemzusammenhangsfunktion, durch die eine Menge gekoppelter linearer Komponenten einer elektrischen Schaltung beschrieben werden, die eine beliebige Anzahl von nichtlinearen Komponenten und linearen Komponenten aufweist, anzugeben, wobei die Menge gekoppelter linearer Komponenten mit einer beliebigen Anzahl nichtlinearer Komponenten gekoppelt ist und deren Durchführung schneller möglich ist und deren Ergebnisse genauere Aussagen über den Systemzustand der Menge linearer Komponenten liefern, als bekannte Verfahren.

Das Problem wird durch das Verfahren gemäß Patentanspruch 1 gelöst.

Bei dem erfindungsgemäßen Verfahren wird für die Menge gekoppelter linearer Komponenten, die in eine beliebige Anzahl von nichtlinearen Komponenten eingebettet ist, ein Differentialgleichungssystem bestimmt, welches eine Zustandsbeschreibung der Menge gekoppelter linearer Komponenten darstellt. Für das homogene Differentialgleichungssystem des Differentialgleichungssystems wird eine vorgebbare Anzahl von Eigenwerten ermittelt und für die Eigenwerte wird ein Fehler bestimmt, der durch die Nichtberücksichtigung der restlichen Eigenwerte des homogenen Differentialgleichungssystems verursacht wird. Liegt der Fehler unter einer vorgebbaren Schranke, ergibt sich die Systemzusammenhangsfunktion aus den Gleichungen des Differentialgleichungssystems, die durch die ermittelten Eigenwerte beschrieben werden. Liegt jedoch der Fehler über der vorgebbaren Schranke, werden solange weitere Eigenwerte für das homogene Differentialgleichungssystem ermittelt und wiederum der Fehler abgeschätzt, bis der Fehler unter der Schranke liegt.

Durch das Verfahren wird eine erhebliche Rechenzeiteinsparung erreicht, da die einzelnen "Inseln" von miteinander gekoppelten linearen Komponenten, also die Menge gekoppelter linearer Komponenten in einfacher Weise schnell berechnet werden können, und dann als sogenannte Black-Box, die durch die Systemzusammenhangsfunktion beschrieben wird, für eine beliebige Anzahl von Verbindungen mit nichtlinearen Komponenten in der elektrischen Schaltung weiter berücksichtigt werden können.

Ferner ist ein erheblicher Vorteil des erfindungsgemäßen Verfahrens darin zu sehen, daß es nunmehr möglich ist, eine beliebige Anzahl von Anschlüssen, also Verbindungen der Menge gekoppelter linearer Komponenten mit nichtlinearen Komponenten oder auch weiteren linearen Komponenten, die in der Menge aus beliebigen Gründen nicht berücksichtigt werden, zu ermitteln.

Auch in der erhöhten Genauigkeit der erzielten Ergebnisse bei der Ermittlung der Systemzusammenhangsfunktion ist ein erheblicher Vorteil zu sehen.

Ferner wird es durch das Verfahren möglich, Schaltungssimulationen für Schaltungen sehr hoher Integrationsdichte trotz Berücksichtigung parasitärer Effekte auf Leitungen durchzuführen.

Vorteilhafte Weiterbildungen der Erfindung ergeben sich aus den abhängigen Ansprüchen.

In einer Weiterbildung des Verfahrens ist es vorteilhaft, die Reihenfolge der Ermittlung der Eigenwerte in der Weise festzulegen, daß die Eigenwerte in bezüglich ihres Informationsgehalts bezüglich des Fehlerkriteriums fallenden Werten ermittelt werden, d. h., daß zu Beginn Eigenwerte mit hohem Informationsgehalt und am Ende Eigenwerte mit lediglich geringem Informationsgehalt bezüglich des Fehlerkriteriums ermittelt werden.

Durch diese Vorgehensweise wird die Genauigkeit der Ergebnisse, also die Genauigkeit der Systemzusammenhangsfunktion bezüglich der Menge gekoppelter linearer Komponenten erhöht, da diejenigen Eigenwerte nicht berücksichtigt werden, die einen geringen Informationsgehalt aufweisen.

Ferner ist es vorteilhaft, die Eigenwerte in der Reihenfolge nach fallender Größe der Eigenwerte zu ermitteln, wodurch die Ermittlung der Eigenwerte weiter vereinfacht wird. Damit ist das Verfahren schneller durchführbar, was zu einer erheblichen Rechenzeiteinsparung bei der Durchführung des Verfahrens führt.

Ein Ausführungsbeispiel des erfindungsgemäßen Verfahrens ist in den Zeichnungen dargestellt und wird im weiteren näher erläutert.

Es zeigen

Fig. 1a und 1b       Skizzen einer sehr einfachen Beispielschaltung, bei der eine Leitung (Fig. la) als eine Menge von gekoppelten linearen Komponenten (Fig. 1b) modelliert wird;

Fig. 2       ein Ablaufdiagramm, in dem die einzelnen Verfahrensschritte dargestellt sind;

Fig. 3       ein Blockdiagramm, in dem eine Rechneranordnung dargestellt ist, mit dem das Verfahren notwendigerweise durchgeführt wird.

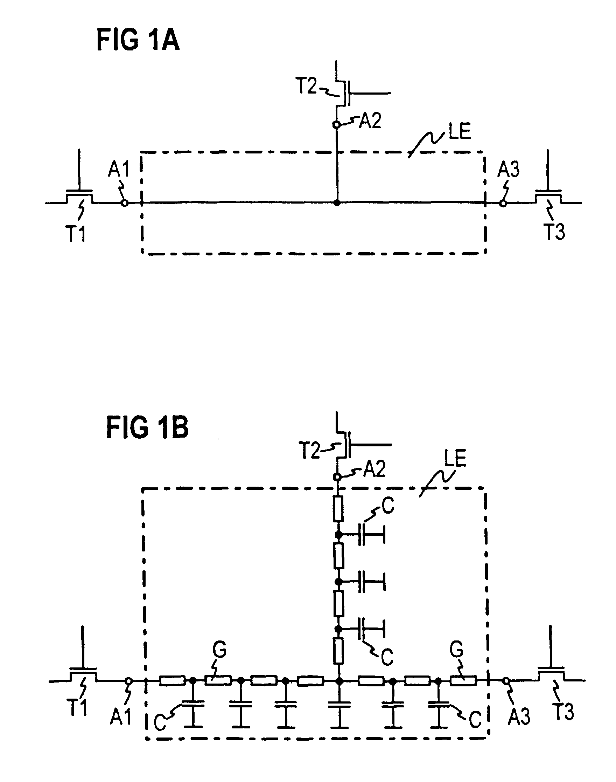

In Fig. 1a ist eine sehr einfache Beispielschaltung mit drei Transistoren T1, T2, T3, die über eine Leitung LE über drei Anschlüsse A1, A2, A3 miteinander gekoppelt sind.

Dieses in Fig. 1a dargestellte sehr einfache Beispiel dient lediglich zur besseren Darstellung des erfindungsgemäßen Verfahrens. Die Allgemeingültigkeit und allgemeine Anwendbarkeit des Verfahrens wird jedoch durch dieses einfache Beispiel in keinster Weise eingeschränkt.

In Fig. 1b ist eine Menge gekoppelter linearer Komponenten dargestellt, mit denen die Leitung LE mit ihren parasitären Effekten modelliert wird, die bei einer sehr hohen Integrationsdichte berücksichtigt werden müssen. Die parasitären Effekte werden bei der Ermittlung eines Zustands der elektrischen Schaltung mit einer hohen Integrationsdichte berücksichtigt.

Wie man an diesem einfachen Beispiel schon erkennt, wird durch die Berücksichtigung der parasitären Effekte in der Leitung LE eine sehr hohe Anzahl linearer, miteinander gekoppelter Komponenten verursacht. Im allgemeinen Fall sind natürlich viele nichtlineare Komponenten, wie beispielsweise die Transistoren T1, T2, T3 miteinander gekoppelt und es müssen auch eine hohe Anzahl von Leitungen LE modelliert werden. Somit kann das Verfahren bei einer elektrischen Schaltung hoher Integrationsdichte auf eine Vielzahl von Mengen gekoppelter linearer Komponenten angewendet werden, wodurch eine Vielzahl von Leitungen LE berücksichtigt und untersucht werden.

Unter linearen Komponenten werden im weiteren beispielsweise ohmsche Widerstände R (R=1/G), lineare Kapazitäten C oder auch lineare Induktivitäten L verstanden. Unter nichtlinearen Komponenten sind beispielsweise jegliche Arten nichtlinearer elektronischer Bauelemente, beispielsweise Transistoren, zu verstehen.

Das Verfahren kann jedoch nicht nur zur Ermittlung einer Systemzusammenhangsfunktion verwendet werden, die eine Menge gekoppelter linearer Komponenten durch Modellierung parasitärer Effekte von Leitungen LE bei Schaltungen sehr hoher Integrationsdichte beschreibt, sondern kann für alle elektrischen Schaltungen eingesetzt werden, bei denen eine Menge gekoppelter linearer Komponenten, die über Anschlüsse mit nichtlinearen Komponenten gekoppelt sind, auftreten. Es ist ferner nicht notwendig, daß die Menge gekoppelter linearer Komponenten ausschließlich mit nichtlinearen Komponenten gekoppelt sind. Es können ebenso an den Anschlüssen der Menge gekoppelter linearer Komponenten weitere lineare Komponenten angeschlossen sein.

Ziel des Verfahrens ist es, für die Menge gekoppelter linearer Komponenten eine Systemzusammenhangsfunktion zu ermitteln, die das Systemverhalten für die Menge gekoppelter linearer Komponenten an den Anschlüssen, in Fig. 1b die Anschlüsse A1, A2 und A3, mit einem möglichst geringen Fehler möglichst schnell und genau angibt.

Die Zahl der Anschlüsse ist bei dem Verfahren beliebig. Allgemein weist die elektrische Schaltung sowohl lineare Komponenten als auch nichtlineare Komponenten auf. Es ist zu betonen, daß in der Menge gekoppelter linearer Komponenten keine nichtlinearen Komponenten vorhanden sein dürfen.

Allgemein formuliert ergibt sich das folgende zu lösende Problem zur Ermittlung einer Systemzusammenhangsfunktion, mit der das Systemverhalten beschrieben wird:

$$\underline{j} = \underline{C} \cdot \frac{d\underline{U}}{dt} + \underline{G} \cdot \underline{U} \tag{1}.$$

Hierbei wird mit $\underline{C}$ eine Kapazitätsmatrix und mit $\underline{G}$ eine Leitwertmatrix und mit $\underline{U}$ ein Vektor von Knotenpotentialen aller Knoten einer linearen Zusammenhangskomponente, also der Menge gekoppelter linearer Komponenten, bezeichnet. Die Kapazitätsmatrix $\underline{C}$ und die Leitwertmatrix $\underline{G}$ können auch Beiträge von Elementen aufweisen, die nur einen linearen Knoten in der Menge gekoppelter linearer Komponenten aufweisen. Die Kapazitätsmatrix $\underline{C}$ und die Leitwertmatrix $\underline{G}$ sind beide positiv semidefinit. Hat die Menge gekoppelter linearer Komponenten eine Anzahl r Anschlüsse, die auch als Randknoten bezeichnet werden, die zwar "nichtlinear" sind, aber über eine lineare Komponente mit einem "linearen" Knoten verbunden sind, und einer Anzahl n innerer Knoten, so haben die Kapazitätsmatrix $\underline{C}$ und die Leitwerksmatrix $\underline{G}$ die Dimension nxn.

Elemente $(\underline{C}_R)_{i,k}$ einer Randkapazitätsmatrix $\underline{C}_R$ mit der Dimensionalität $R^{nxr}$ ergeben sich zu

$$(C_R)_{i,k} = w \tag{2},$$

falls ein Randknoten, also ein Anschluß k über einen Kondensator C der Kapazität w mit einem inneren Knoten i gekoppelt ist.

Elemente $(G_R)_{i,k}$ einer Randleitwertmatrix $\underline{G}_r$ der Dimensionalität $R^{nxr}$ ergeben sich zu

$$(G_R)_{i,k} = \frac{1}{R} \tag{3},$$

falls ein Anschluß k über einen Widerstand R mit einem inneren Knoten i gekoppelt ist, wobei mit R der Wert des Widerstandes R angegeben wird.

Bei Verwendung der oben eingeführten Nomenklatur ergibt sich ein Randstromvektor $\underline{j}$, der durch die jeweiligen Anschlüsse, in Fig. 1b beispielsweise A1, A2, A3 fließt, aus der folgenden Vorschrift:

$$\underline{j} = \underline{C}_R \cdot \frac{d\underline{U}_R}{dt} + \underline{G}_R \cdot \underline{U}_R \tag{4}.$$

Hierbei werden mit $U_R$ Randpotentiale, also die Potentiale der Randknoten (Anschlüsse), bezeichnet.

Eine imaginäre Leitwertmatrix $\underline{B}$ ergibt sich unter Verwendung einer imaginären Kreisfrequenz $\sigma$ zu

$$\underline{B} = \underline{G} + \sigma \cdot \underline{C} \tag{5}.$$

Wird die imaginäre Kreisfrequenz $\sigma > 0$ gewählt und in einer Weise gewählt, daß die imaginäre Leitwertmatrix $\underline{B}$ invertierbar, d. h. positiv definit ist, ergibt sich eine Hilfsmatrix $\underline{A}$ zu:

$$\underline{A} = (\underline{G} + \sigma \cdot \underline{C})^{-1} \cdot \underline{C} = \underline{B}^{-1} \cdot \underline{C} \tag{6}.$$

Nach einigen Umformungen ergibt sich für die Formel (1) in einer umgeschriebenen Form:

$$\underline{A} \cdot \frac{d\underline{U}}{dt} + (\underline{1} - \sigma \cdot \underline{A}) \cdot \underline{U} = \underline{B}^{-1} \cdot \underline{j} \tag{7}.$$

Hierbei wird mit $\underline{1}$ eine Einheitsmatrix bezeichnet.

Nach weiteren Umformungen und bei Verwendung folgender Substitutionen

$$\underline{U} = \underline{W} \cdot \underline{d} \tag{8}$$

und

$$\underline{W}^T \cdot \underline{B} \cdot \underline{A} \cdot \underline{W} = \underline{\Lambda} \tag{9}$$

ergibt sich:

$$\underline{\Lambda} \cdot \frac{d\underline{d}}{dt} + (\underline{1} - \sigma \cdot \underline{\Lambda}) \cdot \underline{d} = \underline{W}^T \cdot \underline{j} \tag{10}.$$

Hierbei wird mit $\underline{W}$ eine Matrix der Dimension $R^{n \times n}$ bezeichnet wird, die die Eigenvektoren $\underline{w}_i$ des jeweiligen Differentialgleichungssystems enthält. Mit $\underline{d}$ wird ein $R^n$-dimensionaler Vektor bezeichnet, der die transformierten Variablen des Differentialgleichungssystems enthält. Diese oben beschriebenen Formeln entsprechen dem üblichen Vorgehen bei einer sogenannten Hauptachsentransformation zur "Entkopplung" (Diagonalisierung) der Variablen eines Differentialgleichungssystems.

Dies stellt ein Eigenwertproblem dar, deren Lösung durch einen beispielsweise aus dem Dokument [1] bekannten Eigenwert-Solver ermittelt wird.

Eine Eigenwertmatrix $\underline{\Lambda}$ ist eine Diagonalmatrix mit den zu ermittelnden Eigenwerten.

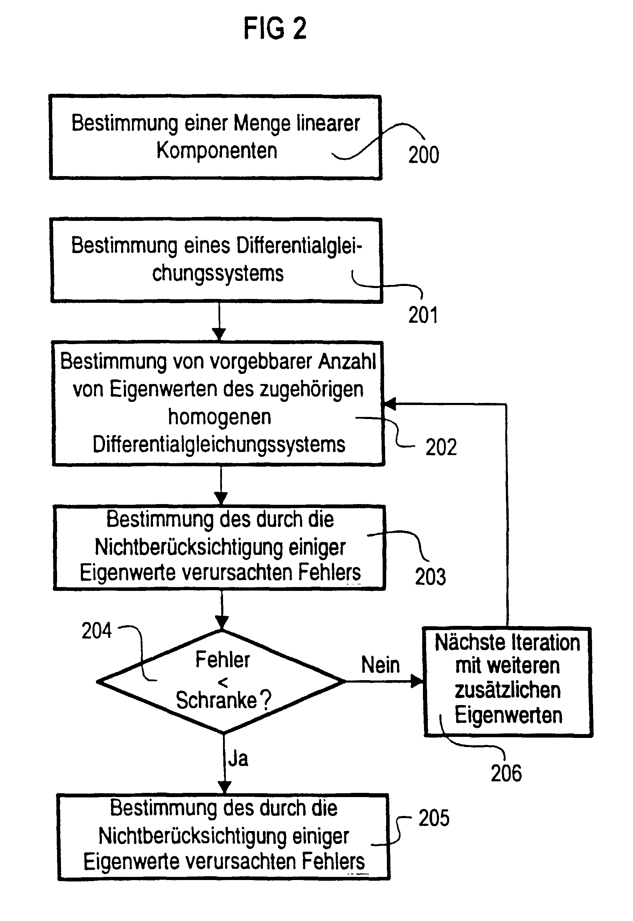

Wie in Fig. 2 dargestellt ist, besteht das Verfahren aus folgenden Verfahrensschritten:

Nach einer Bestimmung der zu bearbeitenden Menge gekoppelter linearer Komponenten 200 wird für die zu untersuchende Menge gekoppelter linearer Komponenten ein Differentialgleichungssystem bestimmt 201, welches die jeweilige Menge gekoppelter linearer Komponenten beschreibt. Dies entspricht dem Aufstellen von Zustandsgleichungen für die Menge gekoppelter linearer Komponenten. Da das Differentialgleichungssystem mit einer Erregung f(t, $\underline{U}$) behaftet ist, die sowohl abhängig ist von der Zeit t als auch abhängig ist von den Knotenpotentialen $\underline{U}$ der Menge gekoppelter linearer Komponenten, ist die Lösung dieses Problems sehr aufwendig.

In einem zweiten Schritt 202 wird nun für das homogene Differentialgleichungssystem des Differentialgleichungssystems mit Hilfe eines Eigenwert-Solvers eine vorgebbare Anzahl von Eigenwerten $\lambda$ ermittelt. Die Anzahl der ermittelten Eigenwerte $\lambda$ ist beliebig. Ist der vorgebbare Teil von Eigenwerten $\lambda$ des homogenen Differentialgleichungssystem ermittelt, wird mittels einer im weiteren beispielhaft dargelegten Funktion zur Fehlerabschätzung, allgemein anhand eines vorgebbaren Fehlerkriteriums ein Fehler ermittelt, der dadurch entsteht, daß die bislang nicht ermittelten Eigenwerte $\lambda$ des homogenen Differentialgleichungssystems bei der Zustandsbeschreibung nicht berücksichtigt werden.

Als Fehlerkriterium können unterschiedlichste Anwendungsaspekte eine Rolle spielen. In diesem einfachen Ausführungsbeispiel wird als Fehlerkriterium beispielhaft ein Laufzeitfehler dargelegt, der sich durch Vernachlässigung einiger Eigenwerte $\lambda$ bei der Zustandsdarstellung der Menge gekoppelter linearer Komponenten ergibt. Ein Phasenfehler $\Delta t$ ergibt sich nach einem etwaigen Einschwingvorgang der elektrischen Schaltung zu

$$\Delta t = \frac{\lambda}{1 - \sigma \cdot \lambda} \tag{11}.$$

Das Fehlerkriterium Laufzeitfehler entspricht dem hier dargestellten Phasenfehler $\Delta t$. Die erwünschte bzw. benötigte Genauigkeit der Systemzusammenhangsfunktion, die die Menge gekoppelter linearer Komponenten beschreibt ist von dem Benutzer vorgebbar. Für die vorgebbare Anzahl ermittelter Eigenwerte $\lambda$ wird der Fehler beispielsweise nach der folgenden Vorschrift ermittelt 203:

Für den Spezialfall, daß die Eigenwerte $\lambda_1$, $\lambda_2$, ..., $\lambda_k$ bezüglich deren Informationsgehalt in fallender Größe ermittelt werden, ist es vorgesehen, daß für einen vorgebbaren Toleranzwert Tol folgende Ungleichung überprüft wird:

$$\frac{\lambda_k}{1 - \sigma \cdot \lambda_k} > Tol \cdot \frac{\lambda_1}{1 - \sigma \cdot \lambda_1}.$$

Dieser Spezialfall bedeutet, daß der Eigenwert $\lambda_1$ einen größeren Informationsgehalt aufweist als der Eigenwert $\lambda_2$, der Eigenwert $\lambda_2$ einen größeren Informationsgehalt aufweist als der Eigenwert $\lambda_3$ usw.

Ein möglicher Wert für den Toleranzwert Tol ist beispielsweise 0.1. Der Toleranzwert Tol ist jedoch vollkommen anwendungsspezifisch und ist frei vorgebbar.

Ist der Fehler kleiner als eine vorgebbare Schranke, die der von dem Benutzer einstellbaren gewünschten bzw. benötigten Genauigkeit entspricht, was in einem weiteren Schritt 204 überprüft wird, so ergibt sich die Systemzusammenhangsfunktion aus den Gleichungen des Differentialgleichungssystems, die durch die bis zu diesem Zeitpunkt ermittelten Eigenwerte Ä beschrieben werden.

Für den oben beschriebenen Spezialfall ist die Schranke implizit in dem Toleranzwert Tol enthalten.

Liegt jedoch der Fehler über der vorgebbaren Schranke 204, so muß die Genauigkeit der Systemzusammenhangsfunktion weiter erhöht werden, was durch weitere Ermittlung von Eigenwerten $\lambda$ für das homogene Differentialgleichungssystem 202, eine erneute Bestimmung des Fehlers 203 und einer erneuten Überprüfung, ob der Fehler unterhalb der vorgebbaren Schranke liegt 204, erreicht wird. Diese Schritte 202, 203, 204 werden solange wiederholt, bis der Fehler bezüglich des Fehlerkriteriums unter der Schranke liegt 205.

In einer Weiterbildung des Verfahrens ist es vorgesehen, die Eigenwerte $\lambda$ in einer Reihenfolge zu bestimmen, daß zuerst Eigenwerte $\lambda$ mit einem hohen Informationsgehalt bezüglich des Fehlerkriteriums ermittelt werden und Eigenwerte $\lambda$ mit bezüglich des Fehlerkriteriums geringem Informationsgehalt erst später ermittelt werden. Damit wird erreicht, daß die zuerst ermittelten Eigenwerte $\lambda$ den höchsten Informationsgehalt bezüglich des Fehlerkriteriums aufweisen, und somit durch die nicht nicht berücksichtigten Eigenwerte $\lambda$ ein minimal möglicher Fehler in der Systemzusammenhangsfunktion verursacht wird.

Für den Spezialfall, daß das Fehlerkriterium in dem Laufzeitfehler zu sehen ist, ist es vorteilhaft, die Reihenfolge der Bestimmung der Eigenwerte derart festzulegen, daß die Eigenwerte $\lambda$ nach fallender Größe ermittelt und auch geordnet werden. Dies ergibt sich daraus, daß bei dem Fehlerkriterium Laufzeitfehler die größten Eigenwerte $\lambda$, also die Eigenwerte $\lambda$, die den größten Wert aufweisen, auch den größten Informationsgehalt bezüglich des Fehlerkriteriums Laufzeitfehler aufweisen.

In diesem Fall werden also die Eigenwerte $\lambda$ der Reihenfolge nach fallender Größe der Eigenwerte $\lambda$ ermittelt.

Es ist in einer Weiterbildung des Verfahrens vorgesehen, daß die Systemzusammenhangsfunktion ein Gleichungssystem ist, welches die durch die Anschlüsse fließenden elektrischen Ströme beschreibt, also die elektrischen Ströme, die zwischen den Verbindungen der Menge gekoppelter linearer Komponenten und den nichtlinearen Komponenten fließt. Diese entsprechen den Ströme in dem einfachen Beispiel aus Figur 1a und 1b, die durch die Anschlüsse A1, A2, A3 fließen.

Die Systemzusammenhangsfunktion ergibt sich für den Fall, daß der ermittelte Fehler kleiner ist als die Schranke als folgende 205:

$$\underline{I} = \underline{C}_R^T \cdot \left( \underline{Q} \cdot \frac{d\,\underline{U}_R}{dt} - \frac{d\,\underline{U}}{dt} \right) + \underline{G}_R^T \cdot \left( \underline{P} \cdot \underline{U}_R - \underline{U} \right) \qquad (12).$$

Mit T wird jeweils eine transponierte Matrix bezeichnet. Mit $\underline{I}$ wird ein Randknotenstromvektor bezeichnet, der die Ströme beschreibt, die durch die Anschlüsse fließt.

Mit $\underline{P}$ wird eine Matrix der Dimension $R^{nxr}$ bezeichnet, deren Elemente $P_{i,\,k}$ den Wert 1 aufweisen, falls ein Randknoten $k$ über einen Widerstand R mit einem Knoten i gekoppelt ist. Mit Q wird eine Matrix der Dimension $R^{nxr}$ bezeichnet, deren Elemente $Q_{i,\,k}$ den Wert 1 aufweisen, falls ein Randknoten $k$ über einen Kondensator C mit einem Knoten i gekoppelt ist.

Mit dieser Systemzusammenhangsfunktion wird der Zustand der Menge linearer Komponenten an den Anschlüssen, beispielsweise A1, A2, A3 beschrieben, womit das Systemverhalten der elektrischen Schaltung mit geringem Fehler durch Nichtberücksichtigung einiger Eigenwerte $\lambda$ schnell bestimmt wird.

Ferner ist es in einer Weiterbildung des Verfahrens vorgesehen, zusätzlich die Differentiale der Systemzusammenhangsfunktion, die die einzelnen Ströme beschreibt, nach den Randknotenpotentialen $\underline{U}_R$ zu berücksichtigen. Es werden in diesem Fall zusätzlich Gleichungen nach der Vorschrift

$$\frac{\partial \underline{I}}{\partial \underline{U}_R} \qquad (13)$$

ermittelt.

Diese Ermittlung kann durch Verwendung numerischer oder geschlossener Integrationsverfahren beliebiger Art, bei numerischen Integrationsverfahrens beispielsweise durch numerische Integration mittels der Trapezregel oder nach der Eulermethode (explizit oder implizit) erfolgen.

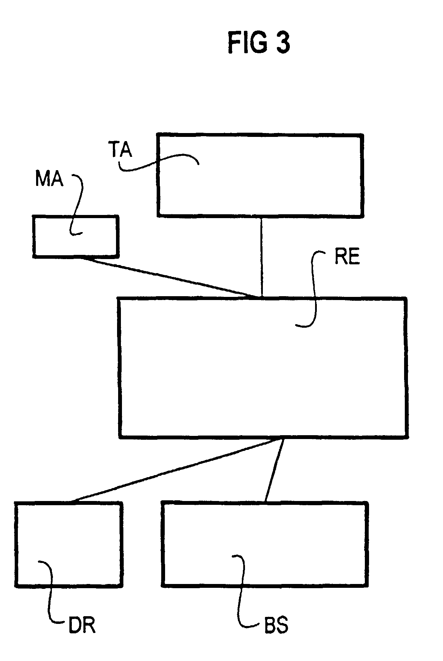

In Fig. 3 ist eine Rechneranordnung dargestellt, mit der das Verfahren notwendigerweise durchgeführt wird. Die Rechneranordnung weist einen Rechner RE und zusätzlich beispielsweise eine Maus MA und/oder eine Tastatur TA zur Eingabe beliebiger Werte durch einen Benutzer auf. Ferner sind beispielsweise in der Rechneranordnung Ausgabemittel, beispielsweise ein Bildschirm BS, der auch als Touch-Screen realisiert sein kann, oder ein Drucker DR, vorgesehen.

In diesem Dokument wurden folgende Veröffentlichungen zitiert:

[1] J. G. Booten et al, A Preconditioned Jacobi-Davidson Method for Solving Large Generalized Eigenvalue Problems, Report NM-R9414, ISSN 0169-0388, CWI, P.O. Box 1090 GB, Amsterdam, Netherlands, S. 1 - 17, 1995

[2] J. Vlach und K. Singhal, Computer Methods for Circuit Analysis and Design, ISBN 0-442-28108-0, Van Nostrand Reinhold Electrical, S. 208 - 234, 1983

[3] K. Glashoff und K. Merten, Neue Verfahren zur Laufzeitberechnung bei Semi-Custom-Schaltungen, Informatik in der Praxis, Springer Verlag, ISBN 3-540-17054-5, S. 13 - 26, 1986

[4] C. L. Ratzlaff und L. T. Pillage, RICE: Rapid Interconnect Circuit Evaluation Using AWE, IEEE Transactions on Computer-Aided Design of Integrated Circuits and Systems, Vol. 13, No. 6, S. 763 - 776, Juni 1994

## Patentansprüche

1. Verfahren zur rechnergestützen Ermittlung einer Systemzusammenhangsfunktion, durch die eine Menge gekoppelter linearer Komponenten einer elektrischen Schaltung beschrieben wird, die eine beliebige Anzahl von nichtlinearen Komponenten und linearen Komponenten aufweist,
a) bei dem für die Menge gekoppelter linearer Komponenten ein Differentialgleichungssystem bestimmt wird (201),
   **dadurch gekennzeichnet daß,**

   b) für ein homogenes Differentialgleichungssystem des Differentialgleichungssystems eine vorgebbare Anzahl von Eigenwerten ermittelt wird (202),
   c) für die Eigenwerte ein Fehler bezüglich eines Fehlerkriteriums ermittelt wird, der dadurch entsteht, daß nicht alle Eigenwerte des homogenen Differentialgleichungssystems berücksichtigt werden (203),
   d) geprüft wird, ob der Fehler unter einer vorgebbaren Schranke liegt (204),
   e) für den Fall, daß der Fehler nicht unter der Schranke liegt, weitere Eigenwerte bestimmt werden und die Verfahrensschritte b) bis d) solange mit weiteren Eigenwerten durchgeführt werden, bis der Fehler unter der Schranke liegt (205),
   f) für den Fall, daß der Fehler unter der Schranke liegt, die Systemzusammenhangsfunktion bestimmt wird aus den Gleichungen des Differentialgleichungssystems, die durch die ermittelten Eigenwerte beschrieben werden (206).

2. Verfahren nach Anspruch 1,
   bei dem die Eigenwerte in der Reihenfolge ihres Informationsgehalts bezüglich des Fehlerkriteriums ermittelt werden.

3. Verfahren nach Anspruch 1,
   bei dem die Eigenwerte in der Reihenfolge nach fallender Größe der Eigenwerte ermittelt werden.

4. Verfahren nach einem der Ansprüche 1 bis 3,
   bei dem das Fehlerkriterium durch einen sich durch die Nichtberücksichtigung von Eigenwerten ergebenden Laufzeitfehler gegeben ist.

5. Verfahren nach einem der Ansprüche 1 bis 4,
   bei dem durch die Systemzusammenhangsfunktion mindestens elektrische Ströme, die zwischen Verbindungen der Menge gekoppelter linearer Komponenten und nichtlinearen Komponenten fließen, beschrieben werden.

6. Verfahren nach Anspruch 5,
   bei dem durch die Systemzusammenhangsfunktion zusätzlich Differentiationen der elektrischen Ströme zwischen Verbindungen der Menge gekoppelter linearer Komponenten und den nichtlinearen Komponenten beschrieben werden.

**7.** Verfahren nach einem der Ansprüche 1 bis 6,
bei dem die linearen Komponenten mindestens gegeben sind durch:

- elektrische Widerstände, und/oder
- elektrische Kapazitäten, und/oder
- elektrische Induktivitäten.

**8.** Verfahren nach einem der Ansprüche 1 bis 7,
bei dem die nichtlinearen Komponenten mindestens durch Transistoren gegeben sind.

**9.** Anordnung zur Ermittlung einer Systemzusammenhangsfunktion, durch die eine Menge gekoppelter linearer Komponenten einer elektrischen Schaltung beschrieben wird, die eine beliebige Anzahl von nichtlinearen Komponenten und linearen Komponenten aufweist, mit
einer Recheneinheit, die eine Einrichtung zum Bestimmen eines Differentialgleichungssystems für die Menge gekoppelter linearer Komponenten aufweist,
**dadurch gekennzeichnet daß,**
die Recheneinheit weiterhin aufweist:

eine Einrichtung zum Ermitteln einer vorgebbaren Anzahl von Eigenwerten für ein homogenes Differentialgleichungssystem des Differentialgleichungssystems;
eine Einrichtung zum Ermitteln eines Fehlers bezüglich eines Fehlerkriteriums für die Eigenwerte, wobei der Fehler dadurch entsteht, daß nicht alle Eigenwerte des homogenen Differentialgleichungssystems berücksichtigt werden;
eine Prüfeinrichtung, die prüft, ob der Fehler unter einer vorgebbaren Schranke (204) liegt, wobei für den Fall, daß der Fehler nicht unter der Schranke liegt, die Eigenwertermittlungseinrichtung solange weitere Eigenwerte bestimmt, bis der Fehler unter der Schranke liegt, und wobei für den Fall, daß der Fehler unter der Schranke (205) liegt, aus den Gleichungen des Differentialgleichungssystems, die durch die ermittelten Eigenwerte beschrieben werden, die Systemzusammenhangsfunktion bestimmt wird.

**10.** Anordnung nach Anspruch 9,
bei der die Eigenwertermittlungseinrichtung derart eingerichtet ist, daß die Eigenwerte in der Reihenfolge ihres Informationsgehalts bezüglich des Fehlerkriteriums ermittelt werden.

**11.** Anordnung nach Anspruch 9,
bei der die Eigenwertermittlungseinrichtung derart eingerichtet ist, daß die Eigenwerte in der Reihenfolge nach fallender Größe der Eigenwerte ermittelt werden.

**Claims**

**1.** Method for computer-aided determination of a system relationship function which is used to describe a set of coupled linear components of an electrical circuit which has any number of non-linear components and linear components,
a) in which a differential equation system is defined (201) for the set of coupled linear components,
characterized in that

b) a predetermined number of eigen values are determined (202) for a homogeneous differential equation system of the differential equation system,
c) for the eigen values, an error is determined with respect to an error criterion, occurring because not all the eigen values of the homogeneous differential equation system are taken into account (203),
d) a check is carried out to determine whether the error is less than a predetermined limit (204),
e) in the case in which the error is not less than the limit, further eigen values are defined and method steps b) to d) are carried out with further eigen values until the error is less than the limit (205),
f) in the case in which the error is less than the limit, the system relationship function is defined from those equations of the differential equation system which are described by the determined eigen values (206).

**2.** Method according to Claim 1,
in which the eigen values are determined in the sequence of their information content with respect to the error criterion.

**3.** Method according to Claim 1,
in which the eigen values are determined in the sequence of falling magnitude of the eigen values.

**4.** Method according to one of Claims 1 to 3,
in which the error criterion is provided by a delay time error which results from ignoring eigen values.

**5.** Method according to one of Claims 1 to 4,
in which the system relationship function describes at least electrical currents which flow between connections of the set of coupled linear components and non-linear components.

**6.** Method according to Claim 5,
in which the system relationship function also describes differentiations of the electrical currents between connections of the set of coupled linear components and the non-linear components.

**7.** Method according to one of Claims 1 to 6,
in which the linear components are provided at least by:

- electrical resistances, and/or
- electrical capacitances, and/or
- electrical inductances.

**8.** Method according to one of Claims 1 to 7,
in which the non-linear components are provided at least by transistors.

**9.** Arrangement for determining a system relationship function which describes a set of coupled linear components of an electrical circuit which has any number of non-linear components and linear components, having
a computer unit which has a device for defining a differential equation system for the set of coupled linear components,
characterized in that
the computer unit furthermore has:

a device for determining a predetermined number of eigen values for a homogeneous differential equation system of the differential equation system;
a device for determining an error with respect to an error criterion for the eigen values, the error occurring because not all the eigen values of the homogeneous differential equation system are taken into account;
a checking device which carries out a check to determine whether the error is less than a predetermined limit (204), and, in the case in which the error is not less than the limit, the eigen-value-determining device defines further eigen values until the error is less than the limit, and, in the case in which the error is less than the limit (205), the system relationship function is defined from those equations of the differential equation system which are described by the determined eigen values.

**10.** Arrangement according to Claim 9,
in which the eigen-value-determining device is set up in such a manner that the eigen values are determined in the sequence of their information content with respect to the error criterion.

**11.** Arrangement according to Claim 9,
in which the eigen-value-determining device is set up in such a manner that the eigen values are determined in the sequence of falling magnitude of the eigen values.

**Revendications**

**1.** Procédé de détermination assistée par ordinateur d'une fonction de convergence d'un système, laquelle fonction décrit une quantité de composants linéaires couplés d'un circuit électrique comportant un nombre quelconque de composants non linéaires et linéaires,

a) dans lequel on détermine pour la quantité de composants linéaires couplés un système d'équations différentielles (201),

caractérisé en ce que

b) on détermine pour un système d'équations différentielles homogène du système d'équations différentielles un nombre prédéfinissable de valeurs propres (202),

c) on détermine pour les valeurs propres une erreur par rapport à un critère d'erreur, qui provient du fait que les valeurs propres du système d'équations différentielles homogène ne sont pas toutes prises en compte (203),

d) on vérifie si l'erreur se situe au-dessous d'une limite prédéfinissable (204),

e) pour le cas où l'erreur ne se situe pas au-dessous de la limite, on détermine d'autres valeurs propres et on effectue les étapes b) à d) du procédé avec d'autres valeurs propres jusqu'à ce que l'erreur se situe au-dessous de la limite (205),

f) pour le cas où l'erreur se situe au-dessous de la limite, on détermine la fonction de convergence du système à partir des équations du système d'équations différentielles, qui sont décrites par les valeurs propres déterminées (206).

2.  Procédé selon la revendication 1, dans lequel les valeurs propres sont déterminées dans l'ordre de leur contenu d'information par rapport au critère d'erreur.

3.  Procédé selon la revendication 1, dans lequel les valeurs propres sont déterminées dans l'ordre selon la grandeur décroissante des valeurs propres.

4.  Procédé selon l'une des revendications 1 à 3, dans lequel le critère d'erreur est donné par une erreur de durée d'exécution provenant de la non-prise en compte de valeurs propres.

5.  Procédé selon l'une des revendications 1 à 4, dans lequel au moins les courants électriques circulant entre les connexions de la quantité de composants linéaires couplés et des composants non linéaires sont décrits par la fonction de convergence du système.

6.  Procédé selon la revendications 5, dans lequel en outre des différenciations des courants électriques circulant entre les connexions de la quantité de composants linéaires couplés et des composants non linéaires sont décrites par la fonction de convergence du système.

7.  Procédé selon l'une des revendications 1 à 6, dans lequel les composants linéaires sont au moins donnés par :

-   des résistances électriques, et/ou
-   des capacités électriques, et/ou
-   des inductances électriques.

8.  Procédé selon l'une des revendications 1 à 7, dans lequel les composants non linéaires sont au moins donnés par des transistors.

9.  Structure de détermination d'une fonction de convergence d'un système, laquelle fonction décrit une quantité de composants linéaires couplés d'un circuit électrique comportant un nombre quelconque de composants non linéaires et de composants linéaires, comprenant une unité arithmétique, qui comporte un dispositif de détermination d'un système d'équations différentielles pour la quantité de composants linéaires couplés,

caractérisé en ce que l'unité arithmétique comporte en outre :

un dispositif de détermination d'un nombre prédéfinissable de valeurs propres pour un système d'équations différentielles homogène du système d'équations différentielles ;

un dispositif de détermination d'une erreur par rapport à un critère d'erreur pour les valeurs propres, laquelle erreur provenant du fait que les valeurs propres du système d'équations différentielles homogène ne sont pas toutes prises en compte ;

un dispositif de contrôle qui vérifie si l'erreur se situe au-dessous d'une limite prédéfinissable (204), et pour le cas où l'erreur ne se situe pas au-dessous de la limite, le dispositif de détermination de valeurs propres détermine d'autres valeurs propres jusqu'à ce que l'erreur se situe au-dessous de la limite et pour le cas où l'erreur se situe au-dessous de la limite, la fonction de convergence du système est déterminée à partir des équations du système d'équations différentielles, qui sont décrites par les valeurs propres déterminées.

10. Structure selon la revendication 9, dans laquelle le dispositif de détermination de valeurs propres est configuré de façon telle que les valeurs propres sont déterminées dans l'ordre de leur contenu d'information par rapport au critère d'erreur.

11. Structure selon la revendication 9, dans laquelle le dispositif de détermination de valeurs propres est configuré de façon telle que les valeurs propres sont déterminées dans l'ordre selon la grandeur décroissante des valeurs propres.

# FIG 1A

# FIG 1B

# FIG 2

Bestimmung einer Menge linearer Komponenten — 200

Bestimmung eines Differentialglei-chungssystems — 201

Bestimmung von vorgebbarer Anzahl von Eigenwerten des zugehörigen homogenen Differentialgleichungssystems — 202

Bestimmung des durch die Nichtberücksichtigung einiger Eigenwerte verursachten Fehlers — 203

204 — Fehler < Schranke ?

Nein → Nächste Iteration mit weiteren zusätzlichen Eigenwerten — 206

Ja

Bestimmung des durch die Nichtberücksichtigung einiger Eigenwerte verursachten Fehlers — 205

# FIG 3